# FASCICULE DE BREVET EUROPEEN

(11) **EP 3 673 278 B1**
(45) Date de publication et mention de la délivrance du brevet: **22.05.2024**
(21) Numéro de dépôt: 18765812.5
(22) Date de dépôt: 22.08.2018
(51) Int. Cl.: G01R 31/364, G01R 31/392, H01M 10/42, H01M 10/48

(54) **ELEMENT ELECTROCHIMIQUE ET BATTERIE AVEC CAPTEUR ET/OU ACTIONNEUR INTEGRE**
ELEKTROCHEMISCHES ELEMENT UND BATTERIE MIT INTEGRIERTEM SENSOR UND/ODER AKTUATOR
ELECTROCHEMICAL ELEMENT AND BATTERY WITH INTEGRATED SENSOR AND/OR ACTUATOR

(30) Priorité: 24.08.2017 FR 1757853
(43) Date de publication de la demande: 01.07.2020
(73) Titulaire: SAFT, 92300 Lavallois-Perret (FR)
(72) Inventeur: BERNARD, Patrick, 33000 Bordeaux (FR); BOREL, Philippe, 33520 Bruges (FR); LE-GUENNE, Laure, 33290 Blanquefort (FR); RIGOBERT, Gérard, 33370 Fargues St Hilaire (FR)
(74) Mandataire: Hirsch & Associés
(86) Numéro de dépôt international: PCT/EP2018/072684
(87) Numéro de publication internationale: WO 2019/038336

(56) Documents cités:
- WO-A1-2016/131764
- US-A1- 2011 048 485
- US-A1- 2013 216 877
- US-A1- 2014 272 500
- US-A1- 2015 301 113
- US-B2- 6 915 220

## Description

### DOMAINE TECHNIQUE

L'invention concerne un élément électrochimique et une batterie comprenant un ou plusieurs éléments électrochimiques, avec capteur et/ou actionneur intégré. Elle trouve notamment une application à la surveillance du fonctionnement d'un élément électrochimique ou d'une batterie de type Li-ion, et/ou au déclenchement d'actions dans un tel élément électrochimique ou une telle batterie, visant à sécuriser l'élément ou la batterie.

### ETAT DE LA TECHNIQUE

Il est connu de disposer des capteurs dans une batterie dans le but par exemple de détecter une élévation de température. Plus généralement, il est connu de disposer des capteurs dans une batterie dans le but d'aider à la gestion de la sécurité de la batterie et/ou des éléments électrochimiques qu'elle contient.

Toutefois, les dispositifs connus nécessitent généralement un système filaire auxiliaire pour l'alimentation électrique des capteurs, ainsi que pour la communication entre les capteurs et l'extérieur, c'est-à-dire la transmission d'information par le capteur vers l'extérieur et la réception d'information provenant de l'extérieur par le capteur.

D'une façon plus générale, les dispositifs connus nécessitent d'utiliser un appareillage complexe et ayant un impact sur les performances électrochimiques de la batterie ou des éléments électrochimiques qu'elle comprend, pour pouvoir accéder à des informations critiques sur le fonctionnement de la batterie ou de ses éléments électrochimiques.

Cet appareillage complexe et les systèmes filaires mentionnés plus haut nécessitent en effet l'utilisation de traversées filaires étanches des enveloppes des éléments électrochimiques, sources de défaillance ou de pollutions internes ou externes, en particulier dans le cas d'une utilisation au coeur de l'élément.

Ces informations critiques sont cependant très importantes, notamment pour aider à la compréhension des éléments électrochimiques, et à la gestion de la sécurité et de la durée de vie de ces éléments, par exemple pour sécuriser une batterie ou l'un de ses éléments en cas d'utilisation abusive pouvant engendrer un feu, ou pouvant avoir un impact mécanique (vibration, choc, etc...). En cas d'une telle utilisation abusive, les systèmes d'alimentation et/ou de communication filaires mentionnés plus haut peuvent eux-mêmes être défaillants.

Certaines des informations critiques qu'il serait important de pouvoir recueillir proviennent de composants ou de zone de l'élément électrochimique auxquels il est difficile d'accéder sans impacter le fonctionnement de l'élément. A défaut de positionner les capteurs aux endroits importants, tel que le coeur d'un élément électrochimique, l'information recueillie est imprécise.

Egalement, il est important de disposer de mécanismes d'actuation à certains endroits d'une batterie ou d'un élément électrochimique d'une batterie, dans le but d'agir au coeur de l'élément pour sécuriser celui-ci, par exemple lors de situations d'utilisations abusives telles que présentées plus haut.

US 2015/0301113 décrit une batterie comprenant un élément de mesure incluant un capteur apte à mesurer un paramètre de la batterie. Le capteur peut-être soit placé à l'intérieur de la batterie elle-même, soit sur le boîtier de la batterie. L'élément de mesure est alimenté par la batterie. Le capteur est plus particulièrement apte à mesurer la tension ou la température. L'élément de mesure comprend en outre une mémoire ainsi qu'un module de communication apte à envoyer et recevoir un signal par voie sans fil. La réception d'un signal peut permettre de faire passer l'élément de mesure en mode veille.

US 2011/0048485 décrit une batterie comprenant des capteurs de tension, de courant, de température et un élément Peltier à la surface du boitier de la batterie.

WO 2016/131764 décrit un élément de connexion électrique de batteries comprenant un capteur. Le capteur peut être alimenté directement par l'élément de connexion ou par une batterie indépendante. La fixation du capteur sur l'élément de connexion peut s'effectuer par collage ou soudage.

US 2014/272500 décrit un système de détection d'une anomalie dans une unité d'énergie. En particulier, il est montré à la figure 13 une unité d'énergie électrochimique configurée pour une détection d'anomalie basée sur la détection d'un rayonnement électromagnétique à l'aide d'une bobine de détection enroulée autour de dispositifs d'énergie électrochimique individuels. La bobine de détection agit comme un capteur pour détecter une anomalie du dispositif autour duquel elle est enroulée.

US 6 915 220 décrit un système intégré de surveillance d'un batterie ou d'un ensemble de batteries, dans lequel un capteur de tension est utilisé pour mesurer le courant circulant de la borne négative d'une cellule vers la terre. Le capteur est alimenté par la cellule elle-même, par l'intermédiaire d'un bloc d'alimentation qui convertit la tension délivrée par la cellule.

US 2013/216877 décrit une batterie incluant une fonction de détection du niveau d'électrolyte au moyen de capteurs disposés à l'extérieur du coffre de la batterie, montés sur un substrat qui pénètre à l'intérieur de la batterie et qui est en contact avec l'électrolyte. Les capteurs sont alimentés par la batterie elle-même ou par une source externe.

### RESUME DE L'INVENTION

Un des buts de l'invention est donc de résoudre notamment les problèmes précités. Ainsi, l'invention a notamment pour objectif de proposer un élément électrochimique et une batterie, pourvus de moyens de mesure d'information et/ou d'actionnement, permettant de surveiller le fonctionnement et/ou d'agir sur le fonctionnement de l'élément ou de la batterie, en vue de sécuriser cet élément ou cette batterie.

L'invention a ainsi pour objet un élément électrochimique comprenant une enveloppe fermée définissant un volume interne à l'intérieur duquel est disposé un faisceau comportant une alternance d'électrodes positives et négatives connectées respectivement à deux bornes de sortie électriques positive et négative et encadrant des séparateurs, ledit faisceau étant imprégné d'électrolyte et par ailleurs connecté par des moyens de connexion 4 à l'une des bornes de sortie électriques.

L'élément électrochimique comprend en outre un ou plusieurs éléments capteur et/ou actionneur auto-alimentés, chacun disposés en contact avec un composant parmi l'enveloppe, le faisceau, les moyens de connexion, et la borne de sortie, et aptes à mesurer une grandeur physique ou chimique relative à, et/ou à générer une action ou un effet physique sur, son environnement.

A la différence de l'état de la technique, où le capteur et/ou actionneur sont alimentés par l'élément électrochimique lui-même ou par une alimentation externe, l'alimentation du capteur et/ou actionneur de l'élément électrochimique selon l'invention n'est pas une alimentation due à l'énergie produite par l'élément électrochimique dans lequel il est placé, mais elle est une alimentation autonome, donc indépendante de toute alimentation provenant de cet élément électrochimique.

Plus précisément, le terme «auto-alimenté» signifie que les éléments capteur et/ou actionneur possèdent leur propre source d'alimentation, et ne sont ni alimentés par l'élément électrochimique dans lequel ou sur lequel ils sont placés, ni alimentés par une alimentation externe. Les éléments capteur et/ou actionneur comprennent ainsi un système interne d'alimentation électrique par exemple de type accumulateur et/ou pile.

Suivant certains modes de réalisation, l'élément électrochimique comprend en outre une ou plusieurs des caractéristiques suivantes, prise(s) isolément ou suivant toutes les combinaisons techniquement possibles :
- le ou les éléments capteur et/ou actionneur comprennent un système d'alimentation électrique de type accumulateur et/ou pile ;
- au moins un des éléments capteur et/ou actionneur est un capteur apte à mesurer une quantité de gaz ou de liquide détecté, et/ou la composition d'un gaz ou d'un liquide détecté, et/ou une concentration saline, et/ou une conductivité, et/ou une contrainte mécanique et/ou une température, et/ou une pression, et/ou une déformation mécanique, et/ou un potentiel électrique ;
- au moins un des éléments capteur et/ou actionneur est un actionneur apte à générer un déplacement, et/ou un effort, et/ou une modification de température, et/ou une modification de pression, et/ou un courant électrique, et/ou une tension électrique, et/ou la libération d'une ou plusieurs substances ou d'un ou plusieurs composés, et/ou l'émission d'un signal électromagnétique, et/ou l'émission d'un signal mécanique ;
- au moins un des éléments capteur et/ou actionneur est un actionneur apte à générer une action ou un effet physique sur son environnement à partir d'une commande externe et/ou à partir de l'atteinte d'une valeur seuil mesurée par ledit au moins un des éléments capteur et/ou actionneur ou par un autre de ces éléments capteurs et/ou actionneurs ;
- au moins un des éléments capteur et/ou actionneur comprend une mémoire apte à stocker une information ;
- au moins un des éléments capteur et/ou actionneur comprend un récepteur apte à réceptionner de l'extérieur une information par voie non filaire ;
- au moins un des éléments capteur et/ou actionneur comprend un transmetteur apte à transmettre vers l'extérieur une information par voie non filaire ;
- au moins un des éléments capteur et/ou actionneur est apte à passer de l'un à l'autre d'un mode de premier niveau de consommation d'énergie, ou mode veille, et d'un mode de deuxième niveau de consommation d'énergie, ou mode de fonctionnement, supérieur au premier niveau de consommation d'énergie ;
- les éléments capteur et/ou actionneur sont aptes à fonctionner sur une plage de température allant de -40 °C à +250 °C, et préférentiellement de -20 °C à +80 °C ;
- les éléments capteur et/ou actionneur sont aptes à fonctionner sous une pression relative par rapport à la pression extérieure sensiblement égale à 15 bars ;
- au moins un des éléments capteur et/ou actionneur présente une forme inscrite dans un volume inférieur ou égal à 125 mm³ ;
- au moins un des éléments capteur et/ou actionneur présente une forme dont la plus grande dimension est inférieure ou égale à 5 mm ;
- au moins un des éléments capteur et/ou actionneur présente une forme inscrite dans un volume inférieur ou égal à 5 mm³, de préférence inférieur ou égal à 1 mm³ ;
- au moins un des éléments capteur et/ou actionneur présente une forme dont la plus grande dimension est sensiblement comprise entre 1000 µm et 100 nm ;
- au moins un des éléments capteur et/ou actionneur est encapsulé dans un, ou revêtu totalement ou partiellement d'un, matériau de protection chimique et/ou d'isolation par rapport à son environnement, tel qu'un matériau métallique, par exemple de l'aluminium, un alliage métallique, par exemple un acier inoxydable, un matériau céramique, un polymère, par exemple un polyoléfine ;
- le ou les éléments capteur et/ou actionneur sont intégrés dans le matériau du composant avec lequel ils sont en contact, ou solidarisés, par exemple par collage ou surmoulage ou soudage, en sa surface ;
- l'élément électrochimique est de type lithium-ion ;
- le faisceau est enroulé autour d'un axe d'enroulement, et au moins un des éléments capteur et/ou actionneur est disposé en contact avec l'axe d'enroulement ;
- au moins un des éléments capteur et/ou actionneur est disposé au niveau d'une des extrémités du faisceau en contact avec les électrodes positives et/ou les électrodes négatives et/ou les séparateurs ;
- au moins un des éléments capteur et/ou actionneur est disposé dans un volume mort situé entre l'enveloppe et l'une des extrémités du faisceau, tel que la zone de coupe circuit ou la zone de connexion de courant ;
- le au moins un des éléments capteur et/ou actionneur est disposé dans la zone de connexion de courant, en contact avec les moyens de connexion et/ou la borne de sortie ;
- au moins un des éléments capteur et/ou actionneur est disposé au coeur du faisceau, en contact avec les électrodes positives et/ou les électrodes négatives et/ou les séparateurs, et/ou dans électrolyte ;
- au moins un des éléments capteur et/ou actionneur est disposé contre, et à l'extérieur de l'enveloppe ;
- au moins un des éléments capteur et/ou actionneur est disposé contre au moins l'une des bornes de sortie, à l'extérieur de l'enveloppe ;
- Selon une forme avantageuse de l'invention, l'élément électrochimique comprend une enveloppe fermée définissant un volume interne à l'intérieur duquel est disposé un faisceau comportant une alternance d'électrodes positives et négatives connectées respectivement à deux bornes de sortie électriques positive et négative et encadrant des séparateurs, ledit faisceau étant imprégné d'électrolyte et connecté par des moyens de connexion à l'une des bornes de sortie électriques, ledit élément électrochimique comprenant un ou plusieurs éléments capteur et/ou actionneur chacun disposé en contact avec un composant parmi l'enveloppe, le faisceau, les moyens de connexion et la borne de sortie, et étant apte à mesurer une grandeur physique ou chimique relative à son environnement, et/ou à générer une action ou un effet physique sur son environnement, et en ce que le ou les éléments capteur et/ou actionneur sont auto-alimentés.

L'invention a également pour objet, selon un deuxième aspect, une batterie comprenant un ou plusieurs éléments électrochimiques électriquement connectés en parallèle et/ou en série, au moins un des éléments électrochimiques étant un élément électrochimique tel que présenté ci-dessus.

L'invention a encore pour objet, selon un troisième aspect, une batterie comprenant plusieurs éléments électrochimiques électriquement connectés en parallèle et/ou en série.

Dans une première variante, au moins deux des éléments électrochimiques sont disposés dans une structure support, et la batterie comprend au moins un premier élément capteur et/ou actionneur auto-alimenté disposé en contact avec la structure support, apte à mesurer une grandeur physique relative à, et/ou à générer une action ou un effet physique sur, son environnement.

Suivant certains modes de réalisation de cette première variante, la batterie comprend en outre une ou plusieurs des caractéristiques suivantes, prise(s) isolément ou suivant toutes les combinaisons techniquement possibles :
- la structure support comprend des pièces de structure, telles qu'une première et une deuxième plaques de maintien entre lesquelles sont disposés les éléments électrochimiques, et le premier élément capteur et/ou actionneur est disposé en contact avec l'une de ces pièces de structure ;
- la structure support comprend un coffre présentant plusieurs parois, et le premier élément capteur et/ou actionneur est disposé en contact avec l'une des parois du coffre ;
- le premier élément capteur et/ou actionneur est intégré dans la structure support ou solidarisé, par exemple par collage ou surmoulage ou soudage, en la surface de ladite structure support ;

Dans une deuxième variante, au moins deux des éléments électrochimiques sont électriquement reliés entre eux par une pièce de connexion électrique, et la batterie comprend en outre au moins un deuxième capteur et/ou actionneur auto-alimenté disposé en contact avec la pièce de connexion électrique apte à mesurer une grandeur physique relative à, et/ou à générer une action ou un effet physique sur, son environnement.

Suivant un mode de réalisation de cette deuxième variante, le deuxième élément capteur et/ou actionneur est intégré dans la pièce de connexion électrique ou solidarisé, par exemple par collage ou surmoulage ou soudage, en la surface de ladite pièce de connexion électrique.

Suivant certains modes de réalisation de la première ou de la deuxième variante, la batterie comprend en outre une ou plusieurs des caractéristiques suivantes, prise(s) isolément ou suivant toutes les combinaisons techniquement possibles :
- le premier et/ou le deuxième capteurs et/ou actionneur comprennent un système d'alimentation électrique de type accumulateur et/ou pile ;
- le premier et/ou le deuxième capteurs et/ou actionneur sont des capteurs aptes à mesurer une quantité de gaz ou de liquide détecté, et/ou la composition d'un gaz ou d'un liquide détecté, et/ou une concentration saline, et/ou une conductivité, et/ou une contrainte mécanique, et/ou une déformation mécanique, et/ou un potentiel électrique ;
- le premier et/ou le deuxième capteurs et/ou actionneur sont des actionneurs aptes générer un déplacement, et/ou un effort, et/ou une modification de température, et/ou une modification de pression, et/ou un courant électrique, et/ou une tension électrique, et/ou la libération d'une ou plusieurs substances ou d'un ou plusieurs composés, et/ou l'émission d'un signal électromagnétique, et/ou l'émission d'un signal mécanique ;
- le premier et/ou le deuxième capteurs et/ou actionneur sont des actionneurs aptes à générer une action ou un effet physique sur son environnement à partir d'une commande externe et/ou à partir de l'atteinte d'une valeur seuil mesurée par ledit premier et/ou deuxième capteur et/ou actionneur ou l'autre de ces dits premier et/ou deuxième capteurs et/ou actionneur, ou mesurée par au moins l'un des éléments capteur et/ou actionneur de l'accumulateur ;
- le premier et/ou le deuxième capteurs et/ou actionneur comprennent une mémoire apte à stocker une information ;
- le premier et/ou le deuxième capteurs et/ou actionneur comprennent un récepteur apte à réceptionner de l'extérieur une information par voie non filaire ;
- le premier et/ou le deuxième capteurs et/ou actionneur comprennent un transmetteur apte à transmettre vers l'extérieur une information par voie non filaire ;
- le premier et/ou le deuxième capteurs et/ou actionneur sont aptes à passer de l'un à l'autre d'un mode de premier niveau de consommation d'énergie, ou mode veille, et d'un mode de deuxième niveau de consommation d'énergie, ou mode de fonctionnement, supérieur au premier niveau de consommation d'énergie ;
- le premier et le deuxième capteurs et/ou actionneur sont aptes à fonctionner sur une plage de température allant de -20 °C à +80 °C ;
- le premier et le deuxième capteurs et/ou actionneur sont aptes à fonctionner sous une pression relative par rapport à la pression extérieure sensiblement égale à 15 bars ;
- le premier et/ou le deuxième capteurs et/ou actionneur présentent une forme inscrite dans un volume inférieur ou égal à 125 mm³ ;
- le premier et/ou le deuxième capteurs et/ou actionneur présentent une forme dont la plus grande dimension est inférieure ou égale à 5 mm ;
- le premier et/ou le deuxième capteurs et/ou actionneur présentent une forme inscrite dans un volume inférieur ou égal à 5 mm³ ;
- le premier et/ou le deuxième capteurs et/ou actionneur présentent une forme dont la plus grande dimension est sensiblement comprise entre 1000 µm et 100 nm ;
- le premier et/ou le deuxième capteurs et/ou actionneur sont encapsulés dans un, ou revêtu totalement ou partiellement d'un, matériau de protection chimique et/ou d'isolation par rapport à son environnement, tel qu'un matériau métallique, par exemple de l'aluminium, un alliage métallique, par exemple un acier inoxydable, un matériau céramique, un polymère, par exemple un polyoléfine.

Ainsi, l'élément électrochimique et la batterie selon l'invention permettent, en complète autonomie, la collecte d'information critique et/ou l'engagement d'actions spécifiques, de façon précise et sans impact sur le fonctionnement de l'élément ou de la batterie, en vue de surveiller le fonctionnement et/ou d'agir sur le fonctionnement de l'élément ou de la batterie, pour pouvoir ainsi sécuriser cet élément ou cette batterie.

En effet, l'élément électrochimique et la batterie selon l'invention ne nécessitent pas de systèmes filaires auxiliaires d'alimentation ou de communication, ou ni d'appareillage complexe, qui pourraient être défaillant lors de situation abusive.

De plus, le fait de ne pas avoir à utiliser de traversées filaires étanches de l'enveloppe de l'élément électrochimique, supprime une source de défaillance ou de pollutions internes ou externes dans le cas d'une utilisation au coeur de l'élément électrochimique.

Le recueil d'informations critiques depuis l'intérieur est sans impact sur les performances électrochimiques de l'élément, donc de la batterie.

La prise d'information par les éléments capteurs et/ou l'engagement d'action par les éléments actionneurs, se fait au plus près des sièges des réactions, ce qui permet l'obtention d'une information extrêmement précise et/ou la réalisation d'une action de façon extrêmement précise, limitant ainsi au maximum la cinétique des mesures, donc n'impactant quasiment pas les mesures ni les performances de l'accumulateur telles que les énergies spécifiques et volumiques.

Les dimensions micrométriques, voire nanométriques, des éléments capteurs et/ou actionneurs permettent une intégration dans des zones importantes, tel que le coeur de l'élément électrochimique (notamment dans le faisceau d'électrodes).

Dans le cas des éléments actionneurs, cela donne la possibilité d'agir au coeur de l'élément électrochimique en générant des phénomènes physico-chimiques propres à sécuriser cet élément lors de situations potentiellement abusives.

### FIGURES

Les caractéristiques et avantages de l'invention apparaîtront à la lecture de la description qui suit, donnée à titre d'exemple, et non limitative, en référence aux figures suivantes :
- figure 1 : représentation schématique d'un exemple d'élément électrochimique selon l'invention, vu en coupe ;
- figure 2 : représentation schématique d'un exemple de batterie selon l'invention.

### EXPOSE DE MODES DE REALISATION

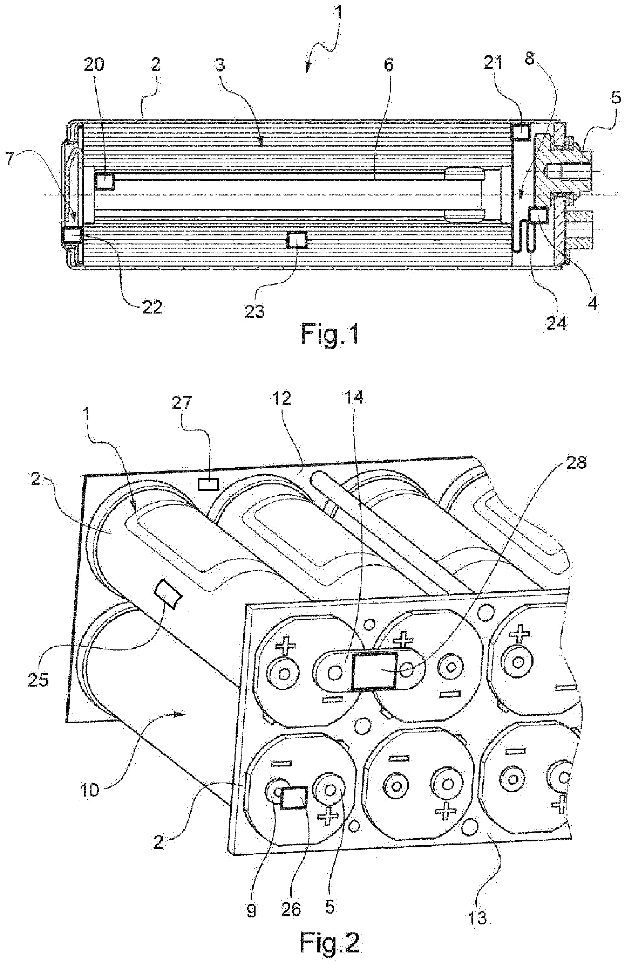

Dans la présente description, un exemple d'élément électrochimique de type Li-ion et de forme d'ensemble cylindrique et présenté (figure 1), ainsi qu'une batterie comprenant plusieurs tels éléments électrochimiques (figure 2). Cependant, toutes les considérations présentées dans cette description, sauf exception mentionnée explicitement, s'appliquent à un élément électrochimique d'un autre type que Li-ion et d'une autre forme d'ensemble qu'une forme strictement cylindrique, ainsi qu'à une batterie comprenant d'autres types d'éléments électrochimiques.

La figure 1 représente donc un exemple d'élément électrochimique 1 selon l'invention, de type Li-ion, et présentant une forme d'ensemble cylindrique.

L'élément 1 comprend une enveloppe 2 fermée définissant un volume interne à l'intérieur duquel est disposé un faisceau 3. Ce faisceau 3 comporte une alternance d'électrodes positives et négatives connectées respectivement à deux bornes de sortie électriques positive et négative dont la borne de sortie 5, et encadrant des séparateurs. Le faisceau 3 est imprégné d'électrolyte. Par ailleurs, ce faisceau 3 est connecté par des moyens de connexion 4 à la borne de sortie 5 électrique.

Sur la figure 2 est représentée une batterie comprenant plusieurs éléments électrochimiques, dont seuls les éléments 1 et 10 sont référencés. L'élément 1 de la batterie de cette figure 2 est identique à l'élément 1 représenté en figure 1. L'élément 10 et les autres éléments non référencés peuvent également être identiques à l'élément 1, au sens notamment de l'intégration d'éléments capteur et/ou actionneur selon l'invention tel que cela sera décrit plus en détail ci-après, ou bien différents, c'est-à-dire ne pas intégrer de tels éléments capteur et/ou actionneurs, ou intégrer une partie seulement de tels éléments capteur et/ou actionneurs, ou encore intégrer de tels éléments capteur et/ou actionneurs mais positionnés différemment.

Ainsi, l'élément électrochimique 1 comprend au moins un élément capteur et/ou actionneur, disposé en contact avec l'un des composants 2 à 5 de l'élément 1. Cet élément capteur et/ou actionneur, dans sa fonction capteur, est apte à mesurer une grandeur physique ou chimique relative à son environnement, et/ou dans sa fonction actionneur, est apte à générer une action ou un effet physique sur son environnement.

Les composants 2 à 5 concernés de l'élément électrochimique 1 sont donc l'enveloppe 2, le faisceau 3, les moyens de connexion 4 et au moins l'une 5 des bornes de sortie . Eventuellement, dans le cas d'un élément électrochimique 1 de forme d'ensemble cylindrique, le faisceau 3 est enroulé autour d'un axe d'enroulement 6, et cet axe d'enroulement 6 peut rentrer dans la liste des composants concernés, avec donc un élément capteur et/ou actionneur en contact avec cet axe d'enroulement 6.

Dans l'exemple représenté, sept éléments capteur et/ou actionneur 20 à 26 sont représentés en contact avec l'un des composants 2 à 6 de l'élément électrochimique 1.

Ainsi :
- l'élément capteur et/ou actionneur 20 est disposé en contact avec le tube d'enroulement 6 ;
- l'élément capteur et/ou actionneur 21 est disposé en contact avec les moyens de connexion 4, par exemple au niveau d'une des extrémités du faisceau 3, en contact avec les électrodes positives et/ou les électrodes négatives et/ou les séparateurs ;
- les éléments capteur et/ou actionneur 22, 24 sont disposés chacun dans un volume mort situé entre l'enveloppe 2 et l'une des extrémités du faisceau 3, par exemple la zone de coupe circuit 7 pour l'élément capteur et/ou actionneur 22 et la zone de connexion de courant 8 pour l'élément capteur et/ou actionneur 24 (dans ce cas, l'élément capteur et/ou actionneur 24 est en contact par exemple avec les moyens de connexion 4 et/ou la borne de sortie 5) ;
- l'élément capteur et/ou actionneur 23 est disposé en contact avec le faisceau 3, par exemple au coeur de ce faisceau 3, en contact avec les électrodes positives et/ou les électrodes négatives et/ou les séparateurs, et/ou dans électrolyte ;
- l'élément capteur et/ou actionneur 25 (visible sur la figure 2) est disposé en contact avec l'enveloppe 2, à l'extérieur de celle-ci ;
- l'élément capteur et/ou actionneur 26 est disposé en contact avec au moins l'une des deux bornes de sortie 5, 9, à l'extérieur de l'enveloppe (2).

L'élément capteur et/ou actionneur 20 peut être positionné plus précisément dans la zone de volume mort, dans l'axe d'enroulement 6, en contact avec ce dernier, et éventuellement avec l'électrolyte libre et/ou avec les gaz libres dans cette zone.

Ce positionnement permet à l'élément capteur et/ou actionneur 20, dans sa fonction capteur, de fournir préférentiellement des informations de pression, température ou de composition chimique des gaz ou liquides dans la zone en question. Dans sa fonction actionneur, l'élément capteur et/ou actionneur 20 peut par exemple générer un courant ou une tension électrique, une contrainte, un effort, un déplacement mécanique, la libération de substances ou de composés, ou encore l'émission d'un signal électromagnétique ou mécanique.

L'élément capteur et/ou actionneur 21 peut être positionné plus précisément de manière à être solidarisé avec les électrodes positives et/ou négatives et/ou les séparateurs, en contact avec ou avec l'électrolyte libre et/ou avec les gaz libres dans cette zone.

Ce positionnement permet à l'élément capteur et/ou actionneur 21, dans sa fonction capteur, de fournir préférentiellement des informations de tension électrique, pression, température, ou de composition chimique des gaz ou liquides dans cette zone. Dans sa fonction actionneur, l'élément capteur et/ou actionneur 21 peut par exemple générer une contrainte, un effort, un déplacement mécanique (pouvant par exemple conduire à la rupture ou la déconnexion d'un composant), un courant ou une tension électrique, la libération de substances ou de composés, ou encore l'émission d'un signal électromagnétique ou mécanique.

L'élément capteur et/ou actionneur 22 peut être positionné plus précisément dans la zone de volume mort telle que la zone de coupe-circuit 7, en contact avec celui-ci et/ou avec l'électrolyte libre et/ou avec les gaz libres dans cette zone, incorporé dans la matière même de l'enveloppe 2 au niveau de cette zone ou solidarisé en sa surface.

Ce positionnement permet à l'élément capteur et/ou actionneur 22, dans sa fonction capteur, de fournir préférentiellement des informations de pression, de contrainte, de déformation, de température, ou de composition chimique des gaz ou liquides dans cette zone. Dans sa fonction actionneur, l'élément capteur et/ou actionneur 22 peut par exemple générer une contrainte, un effort, un déplacement mécanique (pouvant conduire à la rupture ou la déconnexion d'un composant), un courant ou une tension électrique, la libération de substances ou de composés, ou encore l'émission d'un signal électromagnétique ou mécanique.

L'élément capteur et/ou actionneur 23 peut être positionné plus précisément de manière à être solidarisé avec les électrodes positives et/ou négatives et/ou les séparateurs, en contact avec l'électrolyte libre et/ou avec les gaz libres dans cette zone, par exemple par incorporation directe lors des phases de production des électrodes.

Ce positionnement permet à l'élément capteur et/ou actionneur 23, dans sa fonction capteur, de fournir préférentiellement des informations de tension électrique, de pression, de température ou de composition chimique des gaz ou liquides dans la zone en question. Dans sa fonction actionneur, l'élément capteur et/ou actionneur 23 peut par exemple générer une contrainte, un effort, un déplacement mécanique (pouvant conduire à la rupture ou la déconnexion d'un composant), un courant ou une tension électrique, la libération de substances ou de composés pouvant décomposer ou fondre ou dissoudre les matériaux environnant, l'émission d'un signal électromagnétique ou mécanique.

L'élément capteur et/ou actionneur 24 peut être positionné plus précisément dans la zone de volume mort, par exemple dans la zone de connexion de courant 8, en contact avec l'électrolyte libre et/ou avec les gaz libres dans cette zone, par intégration dans, ou en surface de la connectique interne 4 ou l'enveloppe 2.

Ce positionnement permet à l'élément capteur et/ou actionneur 24, dans sa fonction capteur, de fournir préférentiellement des informations de pression, de contrainte, de déformation, de température, de composition chimique des gaz ou liquide dans cette zone. Dans sa fonction actionneur, l'élément capteur et/ou actionneur 24 peut par exemple générer une contrainte, un effort, un déplacement mécanique (pouvant conduire à la rupture ou la déconnexion d'un composant), un courant ou une tension électrique, la libération de substances ou de composés, ou encore l'émission d'un signal électromagnétique ou mécanique.

L'élément capteur et/ou actionneur 25 peut être positionné plus précisément sur, ou dans, la surface l'enveloppe 2 à l'extérieur de l'élément électrochimique.

Ce positionnement permet à l'élément capteur et/ou actionneur 25, dans sa fonction capteur, de fournir préférentiellement des informations de pression, de contrainte, de déformation, de température. Dans sa fonction actionneur, l'élément capteur et/ou actionneur 25 peut par exemple générer un courant ou une tension électrique, ou encore l'émission d'un signal électromagnétique ou mécanique.

L'élément capteur et/ou actionneur 26 peut être positionné plus précisément sur, ou dans, l'une ou l'autre des bornes de sortie 5, 9, à l'extérieur de l'élément électrochimique.

Ce positionnement permet à l'élément capteur et/ou actionneur 26, dans sa fonction capteur, de fournir préférentiellement des informations de température. Dans sa fonction actionneur, l'élément capteur et/ou actionneur 26 peut par exemple générer un courant ou une tension électrique, ou encore l'émission d'un signal électromagnétique ou mécanique.

Par ailleurs, une batterie selon l'invention, dont un exemple est représenté sur la figure 2, comprend également un ou plusieurs éléments capteur et/ou actionneurs, qui dans leur fonction capteur, sont aptes à mesurer une grandeur physique ou chimique relative à leur environnement, et/ou dans leur fonction actionneur, sont aptes à générer une action ou un effet physique sur leur environnement.

Comme expliqué plus haut, la batterie comprend un ou plusieurs éléments électrochimiques 1, 10. Parmi ces éléments électrochimiques 1, 10, un ou plusieurs peuvent être du type présenté ci-dessus, intégrant lui-même un ou plusieurs éléments capteur et/ou actionneurs tel qu'expliqué.

Alternativement, ou en combinaison (comme c'est le cas sur la figure 2), avec la présence d'un ou plusieurs éléments électrochimiques 1 intégrant eux-mêmes un ou plusieurs éléments capteur et/ou actionneurs 20 à 26, la batterie selon l'invention peut comprendre deux ou plusieurs éléments électrochimiques 1, 10 électriquement connectés en parallèle et/ou en série, notamment par l'intermédiaire d'une pièce de connexion électrique 14 elle-même pouvant faire partie de moyens de connexion électrique du type « busbar » ou « jeu de barres ». La batterie comprend en outre un premier élément capteur et/ou actionneur 27 et/ou un deuxième élément capteur et/ou actionneur 28.

Les éléments électrochimiques 1, 10 sont disposés dans une structure support, et le premier élément capteur et/ou actionneur 27 est disposé en contact avec cette structure support 12, 13.

La structure support peut contenir des pièces de structure 12, 13, telles qu'une première et une deuxième plaques de maintien 12, 13 comme représenté sur la figure 2, entre lesquelles sont disposés les éléments électrochimiques 1 à 10. Le premier élément capteur et/ou actionneur 27 peut alors être disposé en contact avec l'une de ces plaques 12, 13, en l'occurrence la plaque 12 sur la figure 2.

La structure support peut également comprendre un coffre présentant plusieurs parois. Le premier élément capteur et/ou actionneur 27 peut alors être disposé en contact avec l'une des parois du coffre.

Quel que soit la structure support, la batterie peut également comprendre un deuxième élément capteur et/ou actionneur 28 tel qu'indiqué plus haut. Ce deuxième élément capteur et/ou actionneur 28 peut être disposé en contact avec la pièce de connexion 14, ou plus généralement avec les moyens de connexion de type « busbar ».

Le positionnement des premier et deuxième éléments capteur et/ou actionneur 27, 28 permet à ces derniers, dans leur fonction capteur, de fournir préférentiellement des informations de température. Dans leur fonction actionneur, les premier et deuxième éléments capteur et/ou actionneur 27, 28 peuvent par exemple générer un courant ou une tension électrique, ou encore l'émission d'un signal électromagnétique ou mécanique.

Dans la suite de la description, et sauf mention contraire explicite, on appelle indifféremment élément capteur et/ou actionneur les éléments capteur et/ou actionneur 20 à 26 intégrés dans ou contre l'élément électrochimique 1, et les premier et deuxième éléments capteur et/ou actionneur 27, 28 intégrés dans la batterie mais non dans l'élément électrochimique 1.

Les éléments capteur et/ou actionneur 20 à 28 sont de type auto-alimentés. Ils ne nécessitent pas l'utilisation d'une source d'énergie extérieure. Plus précisément, le terme « auto-alimenté » signifie que les éléments capteur et/ou actionneur possèdent leur propre source d'alimentation, et ne sont ni alimentés par l'élément électrochimique dans lequel ou sur lequel ils sont placés, ni alimentés par une alimentation externe. Les éléments capteur et/ou actionneur comprennent ainsi un système interne d'alimentation électrique par exemple de type accumulateur et/ou pile. D'autre systèmes internes d'alimentation électriques peuvent être envisagés, seuls ou en combinaison, tel qu'un système utilisant une super-capacité, un élément piézoélectrique, un condensateur, etc....

Les éléments capteur et/ou actionneur 20 à 28, dans leur fonction capteur, peuvent être du type apte à mesurer une ou plusieurs des informations suivantes :
- quantité de gaz ou de liquide détecté,
- composition d'un gaz ou d'un liquide détecté,
- une concentration saline,
- une conductivité,
- une contrainte mécanique,
- une température,
- une pression,
- une déformation mécanique,
- un potentiel électrique

Les éléments capteur et/ou actionneur 20 à 28, dans leur fonction actionneur, peuvent être du type apte à générer une ou plusieurs des actions suivantes, ou un ou plusieurs des effets physiques suivants, sur leur environnement :
- un déplacement,
- un effort,
- une modification de température,
- une modification de pression,
- un courant électrique,
- une tension électrique,
- la libération d'une ou plusieurs substances ou d'un ou plusieurs composés,
- l'émission d'un signal électromagnétique,
- l'émission d'un signal mécanique.

L'action ou l'effet physique généré par l'élément capteur et/ou actionneur 20 à 28 sur son environnement, dans sa fonction actionneur, peut être déclenchée à partir d'une commande externe. Alternativement, ou en combinaison, elle peut également être déclenchée à partir de l'atteinte d'une valeur seuil mesurée par l'élément capteur et/ou actionneur 20 à 28, ou par un autre de ces éléments capteurs et/ou actionneurs 20 à 28, dans sa fonction capteur.

On peut prévoir que les éléments capteur et/ou actionneur 20 à 28 comprennent une mémoire, permettant de stocker une information, qu'il s'agisse d'une information reçue de l'extérieur, ou de l'information mesurée par l'élément capteur et/ou actionneur 20 à 28 lui-même dans sa fonction capteur.

On peut également prévoir que les éléments capteur et/ou actionneur 20 à 28 soit aptes à recevoir de l'extérieur, et/ou à transmettre vers l'extérieur, une information par voie non filaire, au moyen d'un récepteur non filaire, respectivement un transmetteur non filaire.

Les éléments capteur et/ou actionneur 20 à 28 peuvent par ailleurs être configurés pour pouvoir fonctionner en mode veille, c'est-à-dire en mode de premier niveau de consommation d'énergie inférieur au deuxième niveau de consommation d'énergie correspondant au mode de fonctionnement, c'est-à-dire le mode dans lequel l'élément capteur et/ou actionneur 20 à 28 est apte à réaliser sa fonction de capteur et/ou d'actionneur.

Ainsi, les éléments capteur et/ou actionneur 20 à 28 sont aptes à passer de l'un à l'autre du mode de premier niveau de consommation d'énergie, ou mode veille, et du mode de deuxième niveau de consommation d'énergie, ou mode de fonctionnement.

Les éléments capteur et/ou actionneur 20 à 28 peuvent fonctionner dans une plage de température importante. Ils sont de préférence aptes à fonctionner sur une plage de température allant de -40 °C à +250 °C, et encore préférentiellement de -20 °C à +80 °C.

Par ailleurs, les éléments capteur et/ou actionneur 20 à 28 sont aptes à fonctionner sous une pression relative par rapport à la pression extérieure sensiblement égale à 15 bars.

Les éléments capteur et/ou actionneur 20 à 28 sont de taille micrométrique, voire nanométrique.

De préférence, les éléments capteur et/ou actionneur 20 à 28 présentent une ou plusieurs des caractéristiques dimensionnelles suivantes :
- leur forme d'ensemble est inscrite dans un volume inférieur ou égal à 125 mm³ ;
- leur forme d'ensemble présente une plus grande dimension inférieure ou égale à 5 mm ;
- leur forme d'ensemble est inscrite dans un volume inférieur ou égal à 5 mm³, de préférence inférieur ou égal à 1 mm³ ;
- leur forme d'ensemble présente une plus grande dimension sensiblement comprise entre 1000 µm et 100 nm.

De telles dimensions permettent l'intégration de ces éléments capteur et/ou actionneur 20 à 28 au coeur des composants, notamment au coeur du faisceau 3 d'électrodes.

Les éléments capteur et/ou actionneur 20 à 28 sont encapsulés dans un matériau de protection, ou revêtu totalement ou partiellement d'un tel matériau. Ce matériau de protection est apte à procurer à l'élément capteur et/ou actionneur 20 à 28 une protection par exemple de nature chimique, et/ou une isolation électrique, et/ou une étanchéité, par rapport à l'environnement. Il peut s'agir par exemple d'un matériau métallique, tel que de l'aluminium, ou un alliage métallique, tel que de l'acier inoxydable. Il peut aussi s'agir d'un matériau céramique, ou d'un polymère tel qu'un polyoléfine.

D'une façon générale, on peut prévoir que les éléments capteur et/ou actionneur 20 à 28 soient intégrés dans le matériau du composant avec lequel ils sont en contact, ou soient solidarisés, par exemple par collage ou surmoulage ou soudage, en sa surface.

Ainsi, les éléments capteur et/ou actionneur 20 à 26 peuvent être intégrés au composant correspondant 2 à 6 de l'élément électrochimique 1, ou solidarisés en la surface de ce composant 2 à 6. Par ailleurs, le premier élément capteur et/ou actionneur 27 peut être intégré à la structure support de la batterie, ou solidarisé en la surface de cette structure support. Enfin, le deuxième élément capteur et/ou actionneur 28 peut être intégré à la pièce de connexion 14 de la batterie, ou solidarisé en la surface de cette pièce de connexion.

Ci-après sont donnés des exemples de configuration d'un élément électrochimique ou d'une batterie selon l'invention.

### - Exemple 1 :

L'élément électrochimique comprend au moins un élément capteur et/ou actionneur 22 localisé tel que représenté sur la figure 1 (voir plus haut les précisions de localisation).

Cet élément capteur et/ou actionneur 22 est un capteur de pression, protégé par de l'aluminium, soudé à l'enveloppe et mesurant 1 mm³.

Lorsque la pression atteint une valeur seuil de 15 bars, un élément actionneur distinct (non représenté), ou l'élément capteur 22 lui-même qui est dans ce cas à la fois un élément capteur et actionneur 22, envoie un signal par voie non filaire à un système externe de gestion de la batterie qui contient l'élément électrochimique. Le système de gestion de la batterie peut alors couper ou dériver le courant par l'intermédiaire d'un « shunt » ou d'un interrupteur.

### - Exemple 2 :

La batterie comprend au moins un élément capteur et/ou actionneur 28 localisé tel que représenté sur la figure 2 (voir plus haut les précisions de localisation). Cet élément capteur et/ou actionneur 28 est un capteur de température enveloppé dans une matrice polymère, surmoulé.

Lorsque qu'une valeur seuil de 80°C est atteinte, un élément actionneur distinct (non représenté), ou l'élément capteur 28 lui-même qui est dans ce cas à la fois un élément capteur et actionneur 28, envoie un signal par voie non filaire à un système de gestion de la batterie. Le système de gestion de la batterie peut alors couper ou dériver le courant par l'intermédiaire d'un « shunt » ou d'un interrupteur.

### - Exemple 3 :

L'élément électrochimique comprend au moins un élément capteur et/ou actionneur 20 localisé tel que représenté sur la figure 1 (voir plus haut les précisions de localisation). Cet élément capteur et/ou actionneur 20 est un capteur de gaz, protégé par de l'inox, mesurant environ 1 mm3, et collé à l'axe.

Ce capteur 20 stocke à fréquence régulière les données qu'il mesure, données pouvant être ensuite utilisées dans le cadre d'une expertise post-mortem de l'élément électrochimique.

### - Exemple 4 :

L'élément électrochimique comprend au moins un élément capteur et/ou actionneur 23 et un élément capteur et/ou actionneur 22, localisés tel que représenté sur la figure 1 (voir plus haut les précisions de localisation). L'élément capteur et/ou actionneur 23 est un capteur de température, protégé par un polymère, mesurant environ 1 mm3 et disposé au coeur du faisceau, en contact avec les électrodes positives. L'élément capteur et/ou actionneur 22 est un actionneur dont le fonctionnement et le rôle est précisé ci-après.

Le capteur 23 stocke en mode veille les données qu'il mesure. Ces données peuvent être envoyées par protocole sans fil à un système de gestion de la batterie qui contient l'élément électrochimique. Une commande électronique peut alors être envoyée par le système de gestion de la batterie à l'élément actionneur 22, pour piloter cet actionneur 22 configuré pour percer la membrane de sécurité de l'élément électrochimique.

Il est rappelé que la présente description est donnée à titre d'exemple et n'est pas limitative de l'invention, notamment en ce qui concerne le type et la forme d'ensemble des éléments électrochimiques qui ne sont pas nécessairement des éléments Li-ion cylindrique.

## Revendications

1. Elément électrochimique (1, 10) comprenant une enveloppe (2) fermée définissant un volume interne à l'intérieur duquel est disposé un faisceau (3) comportant une alternance d'électrodes positives et négatives connectées respectivement à deux bornes de sortie électriques positive et négative et encadrant des séparateurs, ledit faisceau (3) étant imprégné d'électrolyte et connecté par des moyens de connexion (4) à l'une (5) des bornes de sortie électriques, l'élément électrochimique comprenant un ou plusieurs éléments capteur et/ou actionneur (20 à 26) chacun disposé en contact avec un composant (2 à 6) parmi l'enveloppe (2), le faisceau (3), les moyens de connexion (4), et la borne de sortie (5), et étant apte à mesurer une grandeur physique ou chimique relative à son environnement et/ou à générer une action ou un effet physique sur, son environnement, et en ce que le ou les éléments capteur et/ou actionneur comprennent un système interne d'alimentation électrique en sorte de n'être alimentés ni par l'élément électrochimique, ni par une alimentation externe.

2. Elément électrochimique (1, 10) selon la revendication 1, **caractérisé en ce que** le ou les éléments capteur et/ou actionneur (20 à 26) comprennent un système d'alimentation électrique de type accumulateur et/ou pile.

3. Elément électrochimique (1, 10) selon l'une quelconque des revendications 1 et 2, **caractérisé en ce qu'**au moins un des éléments capteur et/ou actionneur (20 à 26) est un actionneur apte à générer une action ou un effet physique sur son environnement à partir d'une commande externe et/ou à partir de l'atteinte d'une valeur seuil mesurée par ledit au moins un des éléments capteur et/ou actionneur (20 à 26) ou par un autre de ces éléments capteurs et/ou actionneurs (20 à 26).

4. Elément électrochimique (1, 10) selon l'une quelconque des revendications 1 à 3, **caractérisé en ce qu'**au moins un des éléments capteur et/ou actionneur (20 à 26) comprend une mémoire apte à stocker une information.

5. Elément électrochimique (1, 10) selon l'une quelconque des revendications 1 à 4, **caractérisé en ce qu'**au moins un des éléments capteur et/ou actionneur (20 à 26) comprend un récepteur apte à réceptionner de l'extérieur une information par voie non filaire.

6. Elément électrochimique (1, 10) selon l'une quelconque des revendications 1 à 5, **caractérisé en ce qu'**au moins un des éléments capteur et/ou actionneur (20 à 26) comprend un transmetteur apte à transmettre vers l'extérieur une information par voie non filaire.

7. Elément électrochimique (1, 10) selon l'une quelconque des revendications 1 à 6, **caractérisé en ce qu'**au moins un des éléments capteur et/ou actionneur (20 à 26) est apte à passer de l'un à l'autre d'un mode de premier niveau de consommation d'énergie, ou mode veille, et d'un mode de deuxième niveau de consommation d'énergie, ou mode de fonctionnement, supérieur au premier niveau de consommation d'énergie.

8. Elément électrochimique (1, 10) selon l'une quelconque des revendications 1 à 7, **caractérisé en ce qu'**au moins un des éléments capteur et/ou actionneur (20 à 26) présente une forme inscrite dans un volume inférieur ou égal à 125 mm³.

9. Elément électrochimique (1, 10) selon l'une quelconque des revendications 1 à 8, **caractérisé en ce qu'**au moins un des éléments capteur et/ou actionneur (20 à 26) présente une forme dont la plus grande dimension est inférieure ou égale à 5 mm.

10. Elément électrochimique (1, 10) selon l'une quelconque des revendications 1 à 9, **caractérisé en ce qu'**au moins un des éléments capteur et/ou actionneur (20 à 26) présente une forme inscrite dans un volume inférieur ou égal à 5 mm³, de préférence inférieur ou égal à 1 mm³.

11. Elément électrochimique (1, 10) selon l'une quelconque des revendications 1 à 10, **caractérisé en ce qu'**au moins un des éléments capteur et/ou actionneur (20 à 26) présente une forme dont la plus grande dimension est sensiblement comprise entre 1000 µm et 100 nm.

12. Elément électrochimique (1, 10) selon l'une quelconque des revendications 1 à 11, **caractérisé en ce qu'**au moins un des éléments capteur et/ou actionneur (20 à 26) est encapsulé dans un, ou revêtu totalement ou partiellement d'un, matériau de protection chimique et/ou d'isolation par rapport à son environnement, tel qu'un matériau métallique, par exemple de l'aluminium, un alliage métallique, par exemple un acier inoxydable, un matériau céramique, un polymère, par exemple une polyoléfine.

13. Elément électrochimique (1, 10) selon l'une quelconque des revendications 1 à 12, **caractérisé en ce que** le faisceau (3) est enroulé autour d'un axe d'enroulement (6), et **en ce qu'**au moins un (20) des éléments capteur et/ou actionneur (20 à 26) est disposé en contact avec l'axe d'enroulement (6).

14. Elément électrochimique (1, 10) selon l'une quelconque des revendications 1 à 13, **caractérisé en ce qu'**au moins un (21) des éléments capteur et/ou actionneur (20 à 26) est disposé au niveau d'une des extrémités du faisceau (3) en contact avec les électrodes positives et/ou les électrodes négatives et/ou les séparateurs.

15. Elément électrochimique (1, 10) selon l'une quelconque des revendications 1 à 14, **caractérisé en ce qu'**au moins un (22, 24) des éléments capteur et/ou actionneur (20 à 26) est disposé dans un volume mort situé entre l'enveloppe (2) et l'une des extrémités du faisceau (3), tel que la zone de coupe circuit (7) ou la zone de connexion de courant (8).

16. Elément électrochimique (1, 10) selon la revendication 15, **caractérisé en ce que** le au moins un (24) des éléments capteur et/ou actionneur (20 à 26) est disposé dans la zone de connexion de courant (8), en contact avec les moyens de connexion (4) et/ou la borne de sortie (5).

17. Elément électrochimique (1, 10) selon l'une quelconque des revendications 1 à 16, **caractérisé en ce qu'**au moins un (23) des éléments capteur et/ou actionneur (20 à 26) est disposé au coeur du faisceau (3), en contact avec les électrodes positives et/ou les électrodes négatives et/ou les séparateurs, et/ou dans électrolyte.

18. Batterie comprenant un ou plusieurs éléments électrochimiques (1, 10) électriquement connectés en parallèle et/ou en série, **caractérisée en ce qu'**au moins un des éléments électrochimiques (1, 10) est un élément électrochimique selon l'une quelconque des revendications précédentes.

19. Batterie comprenant plusieurs éléments électrochimiques (1, 10) électriquement connectés en parallèle et/ou en série, au moins deux des éléments électrochimiques (1, 10) étant disposés dans une structure support (12, 13), la batterie comprenant au moins un premier élément capteur et/ou actionneur (27) disposé en contact avec ladite structure support, apte à mesurer une grandeur physique relative à, et/ou à générer une action ou un effet physique sur, son environnement, **caractérisée en ce que** ledit au moins un premier élément capteur et/ou actionneur (27) comprend un système interne d'alimentation électrique en sorte de n'être alimentés ni par l'un des éléments électrochimiques, ni par une alimentation externe.

20. Batterie selon la revendication 19, **caractérisée en ce que** la structure support (12, 13) comprend des pièces de structure (12, 13), telles qu'une première et une deuxième plaques de maintien (12, 13) entre lesquelles sont disposés les éléments électrochimiques (1 à 10), et **en ce que** le premier élément capteur et/ou actionneur (27) est disposé en contact avec l'une desdites pièces de structure (12, 13).

21. Batterie selon la revendication 19, **caractérisée en ce que** la structure support comprend un coffre présentant plusieurs parois, et **en ce que** le premier élément capteur et/ou actionneur (27) est disposé en contact avec l'une des parois du coffre.

22. Batterie comprenant plusieurs éléments électrochimiques (1, 10) électriquement connectés en parallèle et/ou en série, au moins deux des éléments électrochimiques (1, 10) étant électriquement reliés entre eux par une pièce de connexion électrique (14), la batterie comprenant au moins un premier élément capteur et/ou actionneur (28) disposé en contact avec la pièce de connexion électrique (14) apte à mesurer une grandeur physique relative à, et/ou à générer une action ou un effet physique sur, son environnement, **caractérisée en ce que** ledit au moins un premier élément capteur et/ou actionneur (27) comprend un système interne d'alimentation électrique en sorte de n'être alimentés ni par l'un des éléments électrochimiques, ni par une alimentation externe.

## Patentansprüche

1. Elektrochemische Zelle (1, 10), umfassend eine geschlossene Hülle (2), die ein inneres Volumen definiert, in dessen Innerem ein Bündel (3) angeordnet ist, umfassend abwechselnde positive und negative Elektroden, die jeweils mit zwei elektrischen Ausgangsanschlüssen, positiv und negativ, verbunden sind und zwei Separatoren umgeben, wobei das genannte Bündel (3) mit Elektrolyt imprägniert ist und durch Verbindungsmittel (4) mit einem (5) der elektrischen Ausgangsanschlüsse verbunden ist, wobei das elektrochemische Element ein oder mehrere Sensor- und/oder Aktuatorelemente (20 bis 26) umfasst, das jeweils in Kontakt mit einer Komponente (2 bis 6) unter der Hülle (2), dem Bündel (3), den Verbindungsmitteln (4) und dem Ausgangsanschluss (5) angeordnet ist, und dafür geeignet ist, um eine physikalische oder chemische Größe in Bezug auf seine Umgebung zu messen und/oder um eine Wirkung oder einen physikalischen Effekt auf seine Umgebung zu generieren, und wobei das oder die Sensor- und/oder Aktuatorelemente ein inneres elektrisches Versorgungssystem umfassen, damit sie weder von dem elektrochemischen Element noch von einer externen Versorgung versorgt werden.

2. Elektrochemische Zelle (1, 10) nach Anspruch 1, **dadurch gekennzeichnet, dass** das oder die Sensor- und/oder Aktuatorelemente (20 bis 26) ein elektrisches Versorgungssystem vom Typ eines Akkumulators und/oder einer Batterie umfassen.

3. Elektrochemische Zelle (1, 10) nach einem der Ansprüche 1 und 2, **dadurch gekennzeichnet, dass** mindestens eines der Sensor- und/oder Aktuatorelemente (20 bis 26) ein Aktuator ist, der dafür geeignet ist, um eine Wirkung oder einen physikalischen Effekt auf seine Umgebung zu generieren, ausgehend von einem externen Befehl und/oder ausgehend von dem Erreichen eines Schwellenwerts, der von dem genannten mindestens einen der Sensor- und/oder Aktuatorelemente (20 bis 26) oder von einem anderen dieser Sensor- und/oder Aktuatorelemente (20 bis 26) gemessen wird.

4. Elektrochemische Zelle (1, 10) nach einem der Ansprüche 1 bis 3, **dadurch gekennzeichnet, dass** mindestens eines der Sensor- und/oder Aktuatorelemente (20 bis 26) einen Speicher umfasst, der dafür geeignet ist, um eine Information zu speichern.

5. Elektrochemische Zelle (1, 10) nach einem der Ansprüche 1 bis 4, **dadurch gekennzeichnet, dass** mindestens eines der Sensor- und/oder Aktuatorelemente (20 bis 26) einen Empfänger umfasst, der dafür geeignet ist, um von der Außenseite eine Information auf drahtlosem Weg zu empfangen.

6. Elektrochemische Zelle (1, 10) nach einem der Ansprüche 1 bis 5, **dadurch gekennzeichnet, dass** mindestens eines der Sensor- und/oder Aktuatorelemente (20 bis 26) einen Transmitter umfasst, der dafür geeignet ist, um an die Außenseite eine Information auf drahtlosem Weg zu übertragen.

7. Elektrochemische Zelle (1, 10) nach einem der Ansprüche 1 bis 6, **dadurch gekennzeichnet, dass** mindestens eines der Sensor- und/oder Aktuatorelemente (20 bis 26) dafür geeignet ist, um von einem zum anderen von einem Modus eines ersten Energieverbrauchspegels, oder Ruhemodus, und einem Modus eines zweiten Energieverbrauchspegels, oder Betriebsmodus, der höher ist als der erste Energieverbrauchspegel, zu wechseln.

8. Elektrochemische Zelle (1, 10) nach einem der Ansprüche 1 bis 7, **dadurch gekennzeichnet, dass** mindestens eines der Sensor- und/oder Aktuatorelemente (20 bis 26) eine Form aufweist, die in einem Volumen von kleiner oder gleich 125 mm³ eingeschrieben ist.

9. Elektrochemische Zelle (1, 10) nach einem der Ansprüche 1 bis 8, **dadurch gekennzeichnet, dass** mindestens eines der Sensor- und/oder Aktuatorelemente (20 bis 26) eine Form aufweist, deren größte Abmessung kleiner oder gleich 5 mm ist.

10. Elektrochemische Zelle (1, 10) nach einem der Ansprüche 1 bis 9, **dadurch gekennzeichnet, dass** mindestens eines der Sensor- und/oder Aktuatorelemente (20 bis 26) eine Form aufweist, die in einem Volumen von kleiner oder gleich 5 mm3, vorzugsweise kleiner oder gleich 1 mm3, eingeschrieben ist.

11. Elektrochemische Zelle (1, 10) nach einem der Ansprüche 1 bis 10, **dadurch gekennzeichnet, dass** mindestens eines der Sensor- und/oder Aktuatorelemente (20 bis 26) eine Form aufweist, deren größte Abmessung im Wesentlichen zwischen 1000 µm und 100 nm beträgt.

12. Elektrochemische Zelle (1, 10) nach einem der Ansprüche 1 bis 11, **dadurch gekennzeichnet, dass** mindestens eines der Sensor- und/oder Aktuatorelemente (20 bis 26) in einem chemischen Schutz- oder Isoliermaterial in Bezug auf seine Umgebung eingekapselt ist oder zur Gänze oder teilweise damit beschichtet ist, wie einem Metallmaterial, zum Beispiel Aluminium, einer Metalllegierung, zum Beispiel einem rostfreien Stahl, einem Keramikmaterial, einem Polymer, zum Beispiel einem Polyolefin.

13. Elektrochemische Zelle (1, 10) nach einem der Ansprüche 1 bis 12, **dadurch gekennzeichnet, dass** das Bündel (3) um eine Wickelachse (6) aufgewickelt ist, und dadurch, dass mindestens eines (20) der Sensor- und/oder Aktuatorelemente (20 bis 26) in Kontakt mit der Wickelachse (6) angeordnet ist.

14. Elektrochemische Zelle (1, 10) nach einem der Ansprüche 1 bis 13, **dadurch gekennzeichnet, dass** mindestens eines (21) der Sensor- und/oder Aktuatorelemente (20 bis 26) auf der Höhe eines der Enden des Bündels (3) in Kontakt mit den positiven Elektroden und/oder den negativen Elektroden und/oder den Separatoren angeordnet ist.

15. Elektrochemische Zelle (1, 10) nach einem der Ansprüche 1 bis 14, **dadurch gekennzeichnet, dass** mindestens eines (22, 24) der Sensor- und/oder Aktuatorelemente (20 bis 26) in einem Totvolumen angeordnet ist, das zwischen der Hülle (2) und einem der Enden des Bündels (3) liegt, wie dem Bereich (7) der Unterbrechung des Stromkreises oder dem Bereich (8) der Stromverbindung.

16. Elektrochemische Zelle (1, 10) nach Anspruch 15, **dadurch gekennzeichnet, dass** das mindestens eine (24) der Sensor- und/oder Aktuatorelemente (20 bis 26) in dem Bereich (8) der Stromverbindung in Kontakt mit den Verbindungsmitteln (4) und/oder dem Ausgangsanschluss (5) angeordnet ist.

17. Elektrochemische Zelle (1, 10) nach einem der Ansprüche 1 bis 16, **dadurch gekennzeichnet, dass** mindestens eines (23) der Sensor- und/oder Aktuatorelemente (20 bis 26) in dem Kern des Bündels (3) in Kontakt mit den positiven Elektroden und/oder den negativen Elektroden und/oder den Separatoren und/oder in dem Elektrolyt angeordnet ist.

18. Batterie, umfassend eine oder mehrere elektrochemische Zellen (1, 10), die elektrisch parallel und/oder in Serie verbunden sind, **dadurch gekennzeichnet, dass** mindestens eine der elektrochemischen Zellen (1, 10) eine elektrochemische Zelle nach einem der vorhergehenden Ansprüche ist.

19. Batterie, umfassend mehrere elektrochemische Zellen (1, 10), die elektrisch parallel und/oder in Serie verbunden sind, wobei mindestens zwei der elektrochemischen Zellen (1, 10) in einer Trägerstruktur (12, 13) angeordnet sind, wobei die Batterie mindestens ein erstes Sensor- und/oder Aktuatorelement (27) umfasst, das in Kontakt mit der genannt Trägerstruktur angeordnet ist und dafür geeignet ist, um eine physikalische Größe in Bezug auf seine Umgebung zu messen und/oder um eine Wirkung oder einen physikalischen Effekt darauf zu generieren, **dadurch gekennzeichnet, dass** das genannte mindestens eine erste Sensor- und/oder Aktuatorelement (27) ein inneres elektrisches Versorgungssystem umfasst, damit es weder von einem der elektrochemischen Zellen noch von einer externen Versorgung versorgt wird.

20. Batterie nach Anspruch 19, **dadurch gekennzeichnet, dass** die Trägerstruktur (12, 13) Strukturelemente (12, 13) umfasst, wie eine erste und eine zweite Halteplatte (12, 13), zwischen denen die elektrochemischen Zellen (1 bis 10) angeordnet sind, und dadurch, dass das erste Sensor- und/oder Aktuatorelement (27) in Kontakt mit einem der genannten Strukturelemente (12, 13) angeordnet ist.

21. Batterie nach Anspruch 19, **dadurch gekennzeichnet, dass** die Trägerstruktur ein Gehäuse umfasst, das mehrere Wände aufweist, und dadurch, dass das erste Sensor- und/oder Aktuatorelement (27) in Kontakt mit einer der Wände des Gehäuses angeordnet ist.

22. Batterie, umfassend mehrere elektrochemische Zellen (1, 10), die parallel und/oder in Serie verbunden sind, wobei mindestens zwei der elektrochemischen Zellen (1, 10) elektrisch miteinander durch ein elektrisches Verbindungselement (14) verbunden sind, wobei die Batterie mindestens ein erstes Sensor- und/oder Aktuatorelement (28) umfasst, das in Kontakt mit dem Verbindungselement (14) angeordnet ist, und das dafür geeignet ist, um eine physikalische Größe in Bezug auf seine Umgebung zu messen und/oder um eine Wirkung oder einen physikalischen Effekt darauf zu generieren, **dadurch gekennzeichnet, dass** das genannte mindestens eine erste Sensor- und/oder Aktuatorelement (27) ein inneres elektrisches Versorgungssystem umfasst, damit es weder von einem der elektrochemischen Zellen noch von einer externen Versorgung versorgt wird.

## Claims

1. An electrochemical cell (1, 10) comprising a closed casing (2) defining an internal volume inside which an electrode plate group (3) is arranged comprising alternating positive and negative electrodes respectively connected to two positive and negative electrical output terminals and arranged on both sides of separators, said electrode plate group (3) being impregnated with electrolyte and connected by connection means (4) to one (5) of the electrical output terminals, the electrochemical cell comprising one or more sensor and/or actuator elements (20 to 26) each arranged in contact with a component (2 to 6) within the group comprising the casing (2), the electrode plate group (3), the connection means (4), and the output terminal (5), and being able to measure a physical or chemical quantity relating to its environment and/or to generate an action or a physical effect on, its environment, and that the at least one first sensor and/or actuator element has an internal source of power so as to neither be powered by one of the electrochemical cells nor by an external power supply.

2. The electrochemical cell (1, 10) according to claim 1, wherein the at least one sensor and/or actuator element (20 to 26) comprises an electrical supply system of the secondary cell and/or primary cell type.

3. The electrochemical cell (1, 10) according to any one of claims 1 to 4, **characterized in that** at least one of the sensor and/or actuator elements (20 to 26) is an actuator capable of generating an action or a physical effect on its environment from an external command and/or upon reaching a threshold value measured by said at least one sensor and/or actuator element (20 to 26) or by another of said sensor and/or actuator elements (20 to 26).

4. The electrochemical cell (1, 10) according to any one of claims 1 to 3, **characterized in that** at least one of said sensor and/or actuator elements (20 to 26) comprises a memory capable of storing information.

5. The electrochemical cell (1, 10) according to any one of claims 1 to 4, **characterized in that** at least one of said sensor and/or actuator elements (20 to 26) comprises a receiver capable of receiving information wirelessly from the outside.

6. The electrochemical cell (1, 10) according to any one of claims 1 to 5, **characterized in that** at least one of said sensor and/or actuator elements (20 to 26) comprises a transmitter capable of transmitting information wirelessly to the outside.

7. The electrochemical cell (1, 10) according to any one of claims 1 to 6, **characterized in that** at least one of said sensor and/or actuator elements (20 to 26) is capable of switching from one to the ot back her of a first power consumption level mode, or sleep mode, and a second power consumption level mode, or operating mode, greater than the first power consumption level.

8. The electrochemical cell (1, 10) according to any one of claims 1 to 7, **characterized in that** at least one of said sensor and/or actuator elements (20 to 26) has a shape that is inscribed within a volume less than or equal to 125 mm³.

9. The electrochemical cell (1, 10) according to any one of claims 1 to 8, **characterized in that** at least one of the said sensor and/or actuator elements (20 to 26) has a shape, the largest dimension of which is less than or equal to 5 mm.

10. The electrochemical cell (1, 10) according to any one of claims 1 to 9, **characterized in that** at least one of said sensor and/or actuator elements (20 to 26) has a shape that is inscribed in a volume less than or equal to 5 mm³, preferably less than or equal to 1 mm³.

11. The electrochemical cell (1, 10) according to any one of claims 1 to 10, **characterized in that** at least one of said sensor and/or actuator elements (20 to 26) has a shape of which the largest dimension is substantially between 1000 µm and 100 nm.

12. The electrochemical cell (1, 10) according to any one of claims 1 to 11, **characterized in that** at least one of said sensor and/or actuator elements (20 to 26) is encapsulated in, or totally or partially coated with a material for chemical protection and/or insulation with respect to its environment, such as a metal material, for example aluminum, a metal alloy, for example a stainless steel, a ceramic material, a polymer, for example a polyolefin.

13. The electrochemical cell (1, 10) according to any one of claims 1 to 12, **characterized in that** the electrode plate group (3) is wound around an axial winding spindle (6), and **in that** at least one (20) of the sensor and/or actuator elements (20 to 26) is arranged in contact with the axial winding spindle (6).

14. The electrochemical cell (1, 10) according to any one of claims 1 to 13, **characterized in that** at least one (21) of said sensor and/or actuator elements (20 to 26) is arranged at one of the ends of the electrode plate group (3) in contact with the positive electrodes and/or the negative electrodes and/or the separators.

15. The electrochemical cell (1, 10) according to any one of claims 1 to 14, **characterized in that** at least one (22, 24) of the said sensor and/or actuator elements (20 to 26) is arranged in an unoccupied space located between the casing (2) and one of the ends of the electrode plate group (3), such as a circuit breaker region (7) or a current connection region (8).

16. The electrochemical cell (1, 10) according to claim 15, wherein the at least one (24) of said sensor and/or actuator elements (20 to 26) is arranged in a current connection region (8), in contact with the connection means (4) and/or the output terminal (5).

17. The electrochemical cell (1, 10) according to any one of claims 1 to 16, **characterized in that** at least one (23) of said sensor and/or actuator elements (20 to 26) is arranged at the core of the electrode plate group (3), in contact with the positive electrodes and/or the negative electrodes and/or the separators, and/or in the electrolyte.

18. A battery comprising one or more electrochemical cells (1, 10) electrically connected in parallel and/or in series, **characterized in that** at least one of the electrochemical cells (1, 10) is the electrochemical cell according to any one of the preceding claims.

19. A battery comprising a plurality of electrochemical cells (1, 10) electrically connected in parallel and/or in series, at least two of the electrochemical cells (1, 10) being arranged in a support structure (12, 13), the battery comprising at least a first sensor and/or actuator element (27) arranged in contact with said support structure, capable of measuring a physical quantity relating to, and/or generating an action or a physical effect on, its environment **characterized in that** the at least one first sensor and/or actuator element (27) has an internal source of power so as to neither be powered by one of the electrochemical cells nor by an external power supply.

20. The battery according to claim 19, **characterized in that** the support structure (12, 13) comprises structural parts (12, 13), such as first and second retaining plates (12, 13) between which the electrochemical cells (1, 10) are arranged, and **in that** a first sensor and/or actuator element (27) is arranged in contact with one of said structural parts (12, 13).

21. The battery according to claim 19, **characterized in that** the support structure comprises a housing having a plurality of walls, and **in that** a first sensor and/or actuator element (27) is arranged in contact with one of the walls of the housing.

22. A battery comprising a plurality of electrochemical cells (1, 10) electrically connected in parallel and/or in series, at least two of the electrochemical cells (1, 10) being electrically connected together by an electrical connection part (14), the battery comprising at least a first sensor and/or actuator element (28) arranged in contact with the electrical connection part (14) capable of measuring a physical quantity relating to, and/or generating an action or a physical effect on its environment, **characterized in that** the at least one first sensor and/or actuator element (27) has an internal source of power so as to neither be powered by one of the electrochemical cells nor by an external power supply.
